# EUROPEAN PATENT APPLICATION

(11) **EP 3 840 044 A1**
(43) Date of publication of application: **23.06.2021**
(21) Application number: 20170697.5
(22) Date of filing: 21.04.2020
(51) Int. Cl.: H01L 27/06, G02B 6/13, H01L 21/762, H01L 27/12, H01L 21/84

(54) **SUBSTRATE AND METHOD FOR MONOLITHIC INTEGRATION OF ELECTRONIC AND OPTOELECTRONIC DEVICES**

(30) Priority: 20.12.2019 EP 19218725
(71) Applicant: IHP GmbH - Innovations for High Performance Microelectronics / Leibniz-Institut für innovative Mikroelektronik, 15236 Frankfurt (Oder) (DE)
(72) Inventor: MAI, Andreas, 15236 Frankfurt (Oder) (DE); KNOLL, Dieter, 15236 Frankfurt (Oder) (DE)
(74) Representative: Eisenführ Speiser

(57) **Abstract**

The invention relates to a silicon-based multifunction substrate. The silicon-based multifunction substrate comprises bulk silicon regions (102) extending from a front surface (104) to a back surface (106) of the silicon-based multifunction substrate and at least one buried oxide layer (108.1, 108.2) laterally arranged between the bulk silicon regions. The buried oxide layer is covered by a structured silicon layer (110.1, 110.2) extending up to the front surface. The structured silicon layer comprises, laterally arranged between the bulk silicon regions, at least two silicon-on-insulator regions, herein SOI regions, with different thicknesses (t2, t3) above the buried oxide layer. The SOI regions of the structured silicon layer are electrically insulated from each other by a respective first trench isolation extending from the front surface to the buried oxide layer.

## Description

The present invention relates to a silicon-based multifunction substrate, an integrated circuit device, a method for fabricating a silicon-based multifunction substrate, and to a method for fabricating an integrated circuit device.

A monolithic integration of elements of different functionality, such as photonic components, optoelectronic components, active and/or passive electronic components is per se known. For instance, integrated circuit devices featuring a monolithic integration of optoelectronic components with electronic components have contributed to major advances in high-data-rate fiber communication applications.

Special substrate structures have been proposed to accommodate different substrate requirements of the different components. Such substrate structures are herein referred to as multifunction substrates.

US 7,339,254 B1 describes a multifunction substrate including a buried silicon oxide layer situated over a silicon substrate and a silicon layer situated over the buried oxide layer, i.e. a silicon-on-insulator (SOI) layer stack on top of a silicon substrate The multifunction substrate further includes a trench formed in the silicon layer and the buried oxide layer. The trench has a bottom surface and a first and a second sidewall, and is situated adjacent to an optical region of the multifunction substrate for accommodating optical components such as waveguides, gratings, and modulators. The structure further includes an epitaxial silicon layer situated in the trench on the silicon substrate. The epitaxial layer and the silicon substrate form a bulk silicon region of the multifunction substrate for accommodating active RF electronic components such as bipolar transistors.

It would be desirable to enable an improved monolithic integration of devices of different functionality on a multifunction substrate.

According to a first aspect of the invention, a silicon-based multifunction substrate is provided. The multifunction substrate comprises:
- bulk silicon regions extending from a front surface to a back surface of the multifunction substrate;
- at least one buried silicon oxide layer laterally arranged between the bulk silicon regions; wherein
- the buried silicon oxide layer is covered by a structured silicon layer extending up to the front surface to form a silicon-on-insulator, herein SOI, substrate region, the SOI substrate region comprising, laterally arranged between the bulk silicon regions, at least two silicon-on-insulator regions with different thicknesses of the structured silicon layer above the buried oxide layer; and wherein
- the SOI regions of the structured silicon layer are electrically insulated from each other by a respective first trench isolation extending from the front surface to the buried oxide layer.

The silicon-based multifunction substrate comprises at least one bulk silicon region extending from a front surface to a back surface of the multifunction substrate. Furthermore, the multifunction substrate comprises at least one structured silicon layer situated over a buried silicon oxide layer. The lateral extension of this structured silicon layer defines a silicon-on-insulator (SOI) substrate region. The SOI substrate region is adjacent to the bulk silicon region. According to the invention, this SOI substrate region comprises at least two SOI regions, which differ from each other by having a different thickness of the structured silicon layer above the buried oxide layer.

Neighboring ones of the SOI regions with different thicknesses of the silicon-on-insulator substrate regions are electrically insulated from each other by a respective first trench isolation extending from the front surface to the buried oxide layer. Thus, the SOI regions form sub-regions of the SOI substrate region, which are adjacent to each other. Adjacent does not exclude that the SOI sub-regions are electrically insulated from each other by the respective first trench isolation.

The silicon-based multifunction substrate of the first aspect is based on the recognition that a structured silicon layer over a buried oxide layer, which forms at least two adjacent SOI regions with different thicknesses, improves flexibility in the planning of the placement of electronic or optoelectronic components on the multifunction substrate. As an example, it is per se known from US 7,339,254 B1, optical components to be placed on the multifunction substrate require to be placed in or on an SOI substrate region with a certain combination of thicknesses of the buried oxide layer and the top silicon layer, while silicon electronic devices, in particular those which offer high RF performance, formed using bipolar Complementary-Metal-Oxide-Semiconductor technology, hereinafter CMOS technology, according to US 7,339,254 B1, require to be positioned in bulk silicon regions of a multifunction substrate. Moreover, it has to be mentioned that SOI-based CMOS technologies require thicknesses of silicon layers above the buried layer that differ from the silicon thickness requirements of the above mentioned optical components.

In contrast, by providing the structured silicon layer above the buried oxide layer in accordance with the present invention, it becomes possible to provide different silicon thicknesses in the SOI substrate region in accordance with different requirements of different components regarding the respective thickness of silicon underneath. Thus, it becomes possible to also place at least some of those components in SOI substrate regions, which according to the prior art would have required a positioning in a bulk substrate region. Thus, different components that according to the prior art would have had to be placed in separate bulk and SOI substrate regions can now be positioned together in the same SOI substrate region. Components, which require a different thickness of silicon than other components that require an SOI substrate region with a given silicon thickness can now be positioned in the same SOI substrate region, by using an SOI sub-region with a different silicon thickness in the same SOI substrate region. In particular, the silicon-based multifunction substrate of the first aspect, by means of its structure, is particularly advantageous for combining photonic elements such as waveguides, light detectors, and light modulators located on or in SOI, high performance passive and active electronic components, like resistors and MOS components, on the same SOI substrate region, and bipolar transistors located in Si-bulk regions. Bipolar transistors located in Si-bulk regions preferably as main active electronic components, in particular in a high frequency regime. Relocating passive electronic components, like resistors or inductivities, from bulk regions, where they are located in state of the art, into SOI regions increases the Q-Factor and reduces substrate capacitance. Furthermore, locating active electronic components like CMOS transistors on the SOI substrate region, which has certain advantages over CMOS transistors in bulk silicon region. Advantageously, such CMOS transistors are faster, more efficient, more radiation resistant and, last but not least, easier to manufacture at the same integration level. Importantly, such CMOS technology requires Si thicknesses above the buried oxide layer, which are thinner than what photonics typically requires.

Thus, such different components can be placed close to each other on the silicon-based multifunctional substrate. This allows achieving particularly short interconnects between photonic and electronic components.

It is a further advantage of the substrate of the present invention that it can be fabricated using a common metal-oxide-semiconductor (MOS) technology, including variants like NMOS, PMOS, CMOS or BiCMOS. Thus, the silicon-based multifunction substrate can be fabricated using highly developed and cost-effective front-end-of-line (FEOL) technology and thus in the same process that in a further processing stage also serves for fabricating electronic and optoelectronic components on the substrate. Of course, it is also possible to provide the substrate of the present invention as an intermediate product that is sold as such, i.e., without components. In the following, embodiments of the silicon-based multifunction substrate will be described.

In some embodiments of the silicon-based multifunction substrate, the structured silicon layer comprises only two types of lateral regions, namely at least one first SOI region and at least one second SOI region. The first SOI region has a first thickness and extends in thickness from the buried oxide layer to a first thickness level that preferably is on an identical plane with the front surface of the bulk silicon region. The second SOI region has a second thickness larger than the first thickness and extends from the buried oxide layer to a second thickness level, which is on a plane different from that of the front surface of the bulk silicon region and thus forms a protrusion. In such embodiments, the buried oxide layer preferably has a predetermined thickness, which is constant in lateral direction.

Suitably, the silicon thickness of the first SOI region is selected to achieve an MOS transistor performance, as desired for a given application case. Preferably, the silicon thickness of the first SOI region is between 6 and 200 nanometers, and more preferably, between 70 and 200 nanometers, and even more preferably between 110 and 200 nanometers. An exemplary thickness for the second silicon thickness is 220 nanometer to achieve high performance of photonic components, in particular low propagation losses of silicon waveguides for O- and C-band application. Suitably, the second thickness should be in the range between 170 and 300 nanometers for photonic components. For example, optical components with an operating wavelength of 1.3 micrometer to 1.55 micrometer is suitable for the second silicon thickness of 220 nanometer. Usually, the thickness of the SOI sub-regions is adjusted depending on application of the components to be used. The precision of the thickness can be adjusted to a precision of plus or minus 3% with known technologies.

Further, the thickness of the buried oxide layer is also depending on the given application case. Typically, electronic components like CMOS transistors require thicknesses of the buried oxide layer between 15 nanometer and 190 nanometer for highly integrated digital applications. Since photonic elements are more sensitive to the thickness of the buried oxide layer than electronic components, the buried oxide layer thickness is adapted for photonic elements. For example, a thicker buried oxide layer reduces optical losses in waveguides. In other words, a thicker buried oxide layer allows a reduced width of the waveguide to achieve the same level of optical losses. This effect saturates as of 2 micrometer of the buried oxide layer. Thus, the thickness of the buried oxide layer is suitably between 1 micrometer and 3 micrometer, preferably between 2 micrometer and 3 micrometer. Even though this thicknesses are not state of the art in terms of highly integrated digital applications for CMOS transistors, the above mentioned advantageous like fastness, more efficiency, more radiation resistance and, last but not least and easier manufacture can be achieved. In summary of the preceding paragraphs, the first thickness positively affects the performance of an above or within the silicon layer situated electronic component. The second thickness in combination with the thickness of the buried oxide layer positively affects the performance of an above or within the silicon layer situated optical or opto-electrical component.

In another embodiment, one of the SOI regions, which has a smaller thickness of the structured silicon layer, is laterally arranged between another one of the SOI regions, which has a larger thickness of the structured silicon layer, and the bulk silicon region. In other words, the first SOI region of the structured silicon layer is, preferably, laterally arranged between the second SOI region and the bulk silicon region. This enables low-parasitic electrical connections are achieved due to short interconnects between bipolar sub-circuits and CMOS sub-circuits. In particular, low-parasitic electrical connections of the bipolar sub-circuits are fabricated in the bulk silicon region and of the CMOS sub-circuits are fabricated in that SOI-region with smaller silicon thickness Thus, signal transmission losses are minimized.

In another embodiment, one of the SOI regions, which has a larger thickness of the structured silicon layer, is laterally arranged between another one of the SOI regions, which has a smaller thickness of the structured silicon layer, and the bulk silicon region. In other words, the second SOI region of the structured silicon layer is laterally arranged between the first SOI region and the bulk silicon region. This enables in particular low-parasitic electrical connections of bipolar transistors fabricated in the bulk silicon region and opto-electronic components, like photodiodes and modulators fabricated in that SOI-region with larger silicon thickness. Such low-parasitic electrical connections are achieved due to short interconnects between the bipolar transistors and the opto-electronic components.

The lateral extensions of the different SOI regions can be set in a substrate design process according to the requirements of a given application case. Preferably, a lateral extension of the first SOI region is larger than 100 nanometer. Here, 100 nanometer is the minimum lateral extension of active silicon for, e.g. accommodating the lateral extension of a single MOS transistor.

In another embodiment, the first lateral SOI region and the bulk silicon are electrically insulated from each other by a second trench isolation. The second isolation trench extends in a depth direction from the front surface to a depth level that is, on the bulk silicon side, deeper than an upper edge of the buried oxide layer and, thus, prevents electrical current leakage.

Preferably, a lateral width of the second trench isolation on the bulk silicon side is larger than the sum of a thickness of the buried oxide layer and the smallest thickness of the structured silicon layer thicknesses. In this context, the lateral width of the second trench isolation on the bulk silicon side means a lateral extension of the second trench isolation in the bulk silicon region. In other words, the lateral extension of the second trench isolation through the bulk silicon region has an amount of at least the thickness of the buried oxide layer plus the smallest thickness of the structured silicon layer thicknesses. Such a lateral width of the second trench isolation on the bulk silicon side is suitable to prevent negative effects on active electrical components, such as bipolar transistors, that can be caused by defects induced by the fabrication of the bulk silicon region. In an alternative embodiment, the second trench isolation is smaller than the sum of a thickness of the buried oxide layer and the smallest thickness of the structured silicon layer thicknesses in a lateral extension on the bulk silicon side. This is particular useful, if the presence of defects in the bulk silicon region is not of concern for a given application. In another embodiment, a lateral width of the second isolation trench on the SOI side is larger than the thickness of the buried oxide layer. In this context, the lateral width of the second trench isolation on the SOI side means a lateral extension of the second trench isolation in the SOI region. Such a lateral width of the second trench isolation on the SOI side is suitable to prevent negative effects on electronic components, such as MOS transistors, that can be caused by undercuts induced by wet etching during the fabrication of the bulk silicon region.

In an alternative embodiment, a lateral width of the second trench isolation on the SOI side is smaller than the thickness of the buried oxide layer. This is particularly useful, if no wet etching is applied during fabrication of the bulk silicon region.

According to a second aspect of the invention, an integrated circuit device is provided. The integrated circuit device comprises:
- a silicon-based multifunction substrate according to an embodiment of the first aspect of the invention, wherein
- active or passive electronic components are arranged on or within the bulk silicon regions forming a bulk electrical region, and wherein
- optical or opto-electronic components are arranged on top or within of that SOI region of the structured silicon layer, which among the at least two SOI regions has a largest thickness above the buried oxide layer.

The structure of the silicon-based multifunction substrate allows a monolithic integration of any suitable combination of active or passive electronic components with active or passive optical or opto-electronic components. Such components can be fabricated using a per-se known FEOL technology. In particular, the silicon multifunction substrate of the first aspect present invention allows fabricating such components having different substrate requirements in the same FEOL fabrication process, which may even involve fabrication of the multifunction substrate itself, as will be explained further below.

Optical components are arranged on top or within of the second SOI region, which has a largest thickness above the buried oxide layer. For example, waveguides that use the entire silicon thickness of the silicon layer of the second SOI region are arranged within of that SOI region, while for example photodiodes are situated on top of the second SOI region. Here, within the second SOI region means inside the second SOI region. The individual requirements of different components can be adjusted by controlling the thickness of the buried oxide layer and the second thickness of the second SOI region. The thickness of the buried oxide layer is in some embodiments selected to be suitable for certain optical or optoelectronic components, which require a certain minimum thickness. The minimum thickness is about 1 micrometer, while 2 micrometer or 3 micrometer are preferred.

Furthermore, also the SOI region of the structured silicon layer, which among the at least two SOI regions has a largest thickness above the buried oxide layer is preferably designed for accommodating optical or optoelectronic components according to the given substrate requirements of specific optical or opto-electronic components. The first thickness of the first SOI region can be adjusted according to individual requirements of different electronic components. In one example, partially depleted MOS transistors are arranged in the first SOI region. Preferably, in this example, a thickness value of the structured silicon layer in the first SOI region is 145 nanometer.

In an embodiment, the integrated circuit device comprises a silicon-based multifunction substrate, the structured silicon layer of which comprises only two types of SOI regions, namely at least one first SOI region and at least one second SOI region. The first SOI region has a first thickness and extends in thickness from the buried oxide layer to a first thickness level that is on an identical plane with the front surface of the bulk silicon region. The second SOI region has a second thickness larger than the first thickness and extends from the buried oxide layer to second thickness level, which is on a plane different from that of the front surface of the bulk silicon region and thus forms a protrusion with respect to the front surface of the bulk silicon region. The integrated circuit device comprises active or passive electronic components, or active components as well as passive components arranged on the first SOI region, which thus can be called an electrical SOI region. Optical or opto-electronic components, or optical components as well as opto-electronic components are arranged on the second SOI region, which can thus be referred to as an optical SOI region.

This embodiment of the integrated circuit device thus advantageously includes optical or opto-electronic components as well electronic components, which require mutually different thicknesses of silicon over the buried oxide layer and on the same SOI substrate region. Further, this integrated circuit device allows additionally combining different electronic components, which are either located on a suitable SOI region or on a bulk silicon region.

In another embodiment, the further active component comprises a MOS component arranged on the first lateral SOI region, which forms the electrical SOI region. Advantageously, the electrical SOI region is laterally arranged between the optical SOI region and the bulk electrical region. Such placement is advantageous to enable short interconnects between bulk electrical sub-circuits, such as bipolar sub-circuits, and electrical SOI sub-circuits, such as CMOS sub-circuits. For illustration purposes, the placement of such different regions is in one example, starting with a bulk electrical region and ending with another bulk electrical region: bulk electrical region - electrical SOI region - optical SOI region - electrical SOI region - bulk electrical region.

In an alternative embodiment, the optical SOI region is laterally arranged between the electrical SOI region and the bulk electrical region. Such placement is advantageous to enable short interconnects between bulk electrical sub-circuits and opto-electrical sub-circuits.

In summary, the integrated circuit device of the second aspect of the present invention has different sub-circuits. First sub-circuits in an optical SOI region comprise photonic components, e.g. couplers, waveguides, Ge photodiodes or modulators, within or on the optical SOI region. Second sub-circuits in a bulk electrical region comprise electronic components, in particular components which require high RF performance, using, e.g., SiGe bipolar transistors, for instance in transimpedance amplifiers or modulator drivers. Digital circuits, which are typically made using a CMOS technology, are arranged in an electrical SOI region and form components of one or more third sub-circuits. The integrated circuit device advantageously connects such sub-circuits of different types in their different regions by an interconnect stack fabricated in a back end of line (BEOL) fabrication process. This way, undesired parasitic pad capacitances or bonding induced inductors are reduced in comparison to hybrid-connection-solutions between the sub-circuits.

According to a third aspect of the invention, a method for fabricating a silicon multifunction substrate is provided. The method comprises
- providing a silicon-on-insulator substrate that comprises a buried oxide layer and a silicon layer which is arranged on the buried oxide layer;
- forming at least one trench extending in a depth direction through the silicon layer and through the buried oxide layer;
- depositing silicon inside the trench to form a bulk silicon region that extends from a front surface to a back surface of the silicon substrate; and
- fabricating different silicon-on-insulator regions, herein SOI regions, with different thicknesses of the silicon layer above the buried oxide layer, including a first SOI region having a first thickness and a second SOI region having a second thickness larger than the first thickness.

The method for fabricating a silicon multifunction substrate suitably starts from an industry-standard silicon-on-insulator (SOI) substrate that comprises a buried oxide layer and a silicon layer which is arranged on the buried oxide layer. A bulk silicon substrate region is fabricated by forming a trench that extends in a depth direction through the silicon layer and through the buried oxide layer, and depositing silicon inside the trench. Preferably, silicon inside the trench is epitaxially grown. In a further fabrication step, different silicon-on-insulator regions with different thicknesses of the silicon layer above the buried oxide layer are fabricated.

In one embodiment, sidewalls of the trench for epitaxial grow silicon inside are covered by a thin silicon-nitride layer to induce a vertical silicon growth.

In some embodiments, the different thicknesses of the silicon layer above the buried oxide layer form protrusions. Forming a protrusion is a technologically simple and therefore preferred solution for integrating the fabrication of the structured silicon layer in a CMOS fabrication process.

For comparison, it is more complex to fabricate the structured silicon layer by removing parts of it to subsequently structure the buried oxide layer and then re-grow the silicon layer to achieve a flat silicon surface on top and different thicknesses of the structured silicon layer. Such fabrication needs, in contrast to the preferred solution, distinct fabrication steps to form a first kind of trenches extending in a depth direction through the silicon layer and fully through the buried oxide layer and a second kind of trenches extending in a depth direction through the silicon layer and forming only a recess in the buried oxide layer.

In one embodiment of the method, fabricating the different SOI regions comprises thinning the silicon layer partially using a laterally structured mask. Preferably, for thinning the silicon layer partially physical dry etching is used. Alternatively, or additionally, chemical wet etching can be used. In another variant oxidation is used for thinning.

In an alternative to the embodiment of the last paragraph, fabricating the different lateral SOI regions comprises forming partially thickening the silicon layer using an epitaxial growth process and a laterally structured mask.

In another embodiment, the method further comprises an oxidation of the front surface of the silicon multifunction substrate after fabricating the different lateral SOI regions. Such oxidation smoothes the front surface of the silicon multifunction substrate. Further, the oxidation enables a defect-free front surface. According to fourth aspect of the invention, a method for fabricating an integrated circuit device is provided. The method comprises:
- fabricating a silicon multifunction substrate according to the method of the third aspect of the invention;
- fabricating transistors on at least one of the bulk silicon regions, thus forming bulk silicon electronic regions;
- fabricating at least one electronic component on at least one first lateral SOI region; and
- fabricating at least one optical or opto-electronic component on the second lateral SOI region.

Preferably, the fabrication of transistors on the bulk silicon region, electronic components on the first lateral SOI region and optical or opto-electronic component on the second lateral SOI region occurs in a FEOL fabrication process. Thus, the method for fabricating an integrated circuit device is a preferred solution for integrating the fabrication process in an industry-compatible CMOS fabrication process.

In the following, further embodiments will be described with reference to the enclosed drawings. In the drawings:
Fig. 1 shows a schematic cross-sectional view of a first embodiment of the silicon multifunction substrate;
Fig. 2 shows a schematic cross-sectional view of a second embodiment of the silicon multifunction substrate;
Fig. 3 shows a schematic cross-sectional view of an embodiment of the integrated circuit device;
Fig. 4 shows a block diagram of an embodiment of the method for fabricating a silicon multifunction substrate; and
Fig.5 shows a block diagram of an embodiment of the method for fabricating an integrated circuit device.

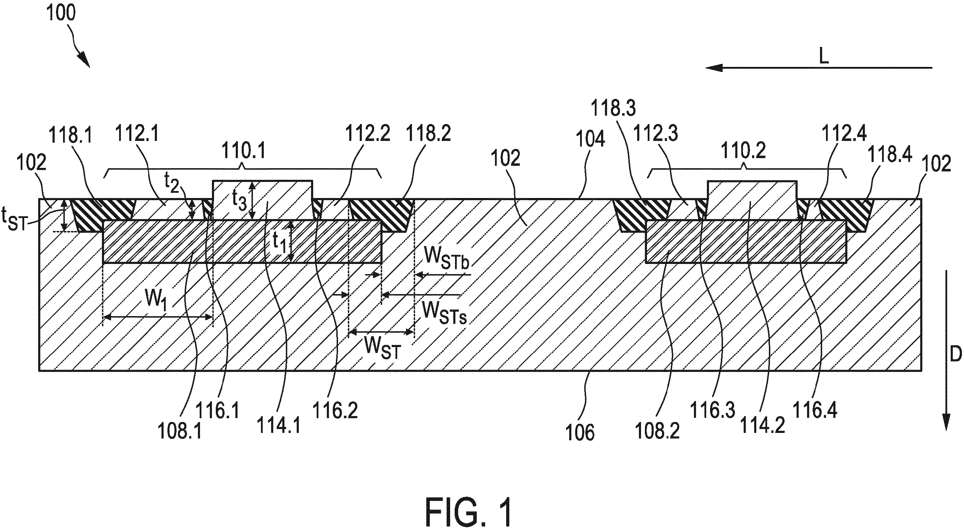

Fig. 1 shows a schematic cross-sectional view of an embodiment of the silicon multifunction substrate 100 for monolithic integration of electronic and optoelectronic devices. The silicon multifunction substrate 100 comprises a bulk silicon region 102, which extends from a front surface 104 to a back surface 106 of the silicon multifunction substrate 100 and two buried oxide layers 108.1, 108.2 laterally arranged between the bulk silicon regions 102. The buried oxide layers 108.1, 108.2 are covered by structured silicon layers extending up to the front surface 104 of the silicon multifunction substrate 100 to form silicon-on-insulator substrate regions 110.1, 110.2. The silicon-on-insulator substrate regions 110.1, 110.2 comprise three silicon-on-insulator regions 112.1, 112.2, 114.1, 112.3, 112.4, 114.2 with two different thicknesses t2, t3 above the buried oxide layers 108.1, 108.2. In this embodiment, the silicon-on-insulator regions 112.1, 112.2, 112.3, 112.4 have the thickness t2 and the silicon-on-insulator regions114.1, 114.2 has the thickness t3. The buried oxide layers 108.1, 108.2 have in lateral extension a constant thickness t1. In this embodiment, the thickness t3 of second silicon-on-insulator regions 114.1, 114.2, which is arranged adjacent laterally to first silicon-on-insulator regions 112.1, 112.4, 112.2, 112.3, is larger than the thickness t2 of the first silicon-on-insulator regions 112.1, 112.2, 112.3, 112.4. Thus, the thickness t3 of the second silicon-on-insulator regions 114.1, 114.2 protrudes on a plane different from that of the front surface 104 of the bulk silicon region 102.

In this embodiment of the multifunction substrate the thickness t2 is 140 nanometer, the thickness t3 is 220 nanometer and the thickness t1 is 2 micrometer.

Neighboring lateral SOI regions 112.1, 112.2, 114.1, 112.3, 112.4, 114.2 of the silicon-on-insulator substrate regions 110.1, 110.2 are electrically insulated from each other by a respective first trench isolation 116.1, 116.2, 116.3, 116.4. The first trench isolation 116.1, 116.2, 116.3, 116.4 extends from the front surface 104 to the buried oxide layer 108.1, 108.2.

The first silicon-on-isolator regions 112.1, 112.2, 112.3, 112.4 are laterally arranged between the second lateral SOI region 114.1, 114.2 and the bulk silicon region 102. Thus, a low-loss interconnects are formed. The bulk silicon region 102 and the first silicon-on-isolator regions 112.1, 112.2, 112.3, 112.4 are electrically insulated from each other by a second trench isolation 118.1, 118.2. The second isolation trench has a thickness t_{ST}, which extends in a depth direction D from the front surface 104 to a depth level deeper than an upper edge of the buried oxide layer 108.1, 108.2. In this embodiment, the thickness t_{ST} is 400 nanometer.

In other embodiments, the thickness t_{ST} is between 250 nanometer and 500 nanometer.

A lateral width W1 of the first lateral SOI regions 112.1, 112.2, 112.3, 112.4 is larger than 100 nanometer.

The lateral width W_{ST} of the second trench isolation 118.1, 118.2, 118.3, 118.4 is the sum of a lateral width of the second trench isolation on the bulk silicon side W_{STb} and of a lateral width of the second trench isolation on the SOI side W_{STs}. The lateral width of the second trench isolation on the bulk silicon side W_{STb} is a lateral extension of the second trench isolation in the bulk silicon region. The width W_{STb} is larger than the sum of the thickness t1 of the buried oxide layer 108.1, 108.2 and the thickness t3 of the second silicon-on-insulator regions 114.1, 114.2.The lateral width W_{STb} of the second trench isolation118.1, 118.2, 118.3, 118.4 is suitable to reduce negative effects that can be caused by defects induced during the fabrication of the multifunction substrate. Such defects can be crystallinity defects in the bulk silicon region 102.

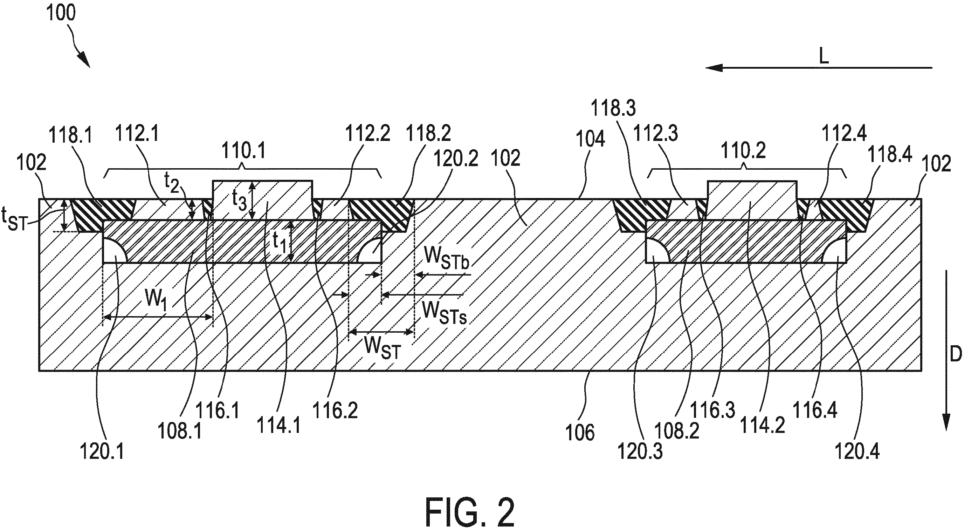

Fig. 2 shows a schematic cross-sectional view of a second embodiment of a silicon multifunction substrate 100'. The following discussion will focus on differences between the silicon multifunction substrate 100 of Fig. 1 and the silicon multifunction substrate 100' of Fig. 2. Those features that are not altered are referred to using the same reference numerals as used in Fig. 1.

The silicon multifunctional substrate 100' has undercuts 120.1, 120.2, 120.3, 120.4 induced by wet etching during the fabrication of the bulk silicon region. A lateral width W_{ST} of the second trench isolation 118.1, 118.2, 118.3, 118.4 is the sum of a lateral width of the second trench isolation on the bulk silicon side W_{STb} and a lateral width of the second trench isolation on the SOI side W_{STs}. Here, the lateral width of the second isolation trench on the SOI side W_{STs} is larger than the thickness of the buried oxide layer 108.1, 108.2. Such a lateral width of the second trench isolation on the SOI side W_{STs} is suitable to prevent negative effects on electronic components.

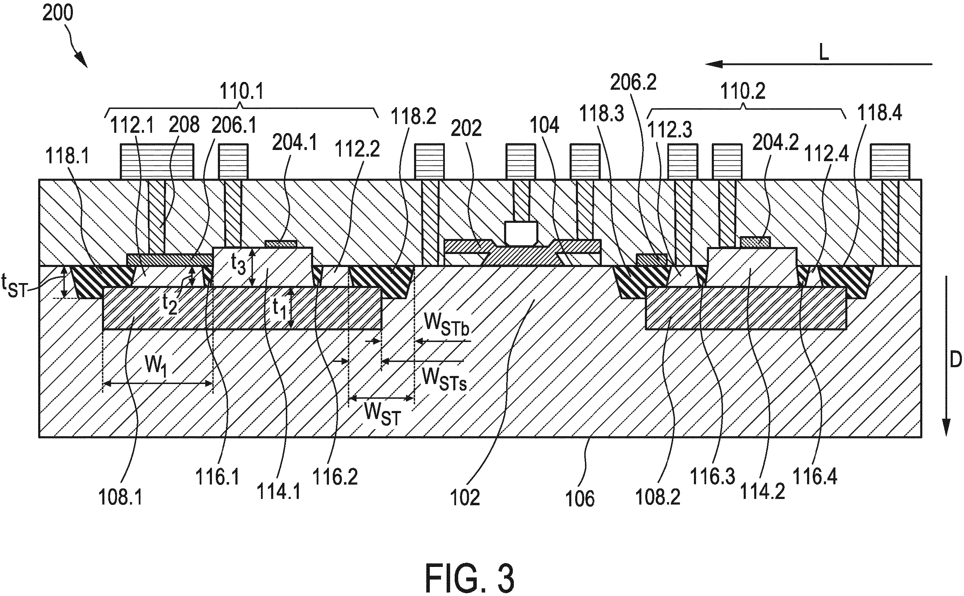

Fig. 3 shows a schematic cross-sectional view of an embodiment of the integrated circuit device 200. The integrated circuit device 200 includes the silicon multifunction substrate 100 of Fig. 1. Thus, the numbering of those components of Fig. 3, which have a correspondence in the embodiment of Fig. 1, can be converted to the numbering of Fig. 1 by subtracting 100 from each number. Therefore, reference is also made to the description of Fig. 1.

The integrated circuit device 200 of Fig. 3 comprises in addition to the silicon multifunction substrate 100 of Fig. 1, an RF bipolar transistor 202 with base and emitter structures on top of and a collector structure largely within the bulk silicon region 102, photodiodes 204.1, 204.2, which are arranged on top of or partly within the second lateral SOI regions 114.1, 114.2, and CMOS transistors 206.1, 206.2 with gate structures which are arranged on top of the first lateral SOI regions 112.1, 112.3.

The RF bipolar transistor 202 with structures on top of and within the bulk silicon region 102 forms a bulk electrical region. The photodiodes 204.1, 204.2, arranged on top of or partly within the second lateral SOI regions 114.1, 114.2 form optical SOI regions and the MOS transistors 206.1, 206.2 with gate structures arranged on top of the first lateral SOI regions 112.1, 112.3 form electrical SOI regions. The placement of such different regions is starting with a bulk electrical region and ending with another bulk electrical region: bulk electrical region - electrical SOI region - optical SOI region - electrical SOI region - bulk electrical region.

The optical and electronic components are not limiting to such examples. In other variants of the integrated circuit device 200 of Fig. 3 numerous bipolar transistors or CMOS transistors can be arranged on top of the bulk silicon region. Further, optical components can be waveguides or light modulators and electronic components can be passive electronic components like resistors. In such alternatives the thicknesses t1, t2 and t3 of the silicon multifunction substrate 100 are selected with respect of the respective requirements of the respective components.

The RF bipolar transistor 202, the photodiodes 204.1, 204.2 and the MOS transistors or resistors 206.1, 206.2 can be fabricated by FEOL technology and electrically connected via electric interconnects 208.

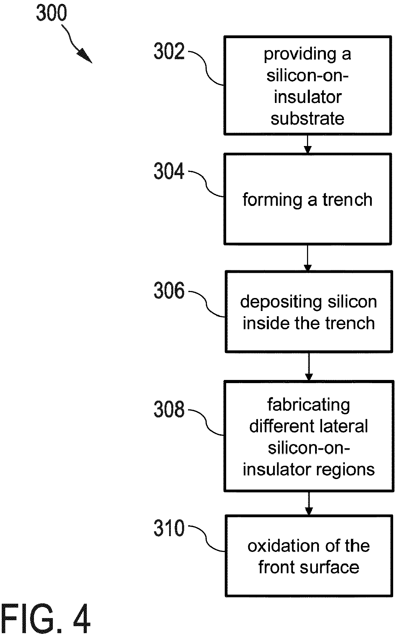

Fig. 4 shows a block diagram of an embodiment of the method 300 for fabricating a silicon multifunction substrate 100 for monolithic integration of electronic and optoelectronic devices, which is explained in Fig. 1.

The method for fabricating a silicon multifunction substrate starts from an industry-standard silicon-on-insulator (SOI) substrate that comprises a buried oxide layer and a silicon layer which is arranged on the buried oxide layer. A first step 302 of the method is providing a silicon-on-insulator substrate that comprises a buried oxide layer and a silicon layer which is arranged on the buried oxide layer. A bulk silicon substrate region is fabricated in a second step 304 by forming a trench that extends in a depth direction through the silicon layer and through the buried oxide layer and depositing in step 306 silicon inside the trench. The silicon inside the trench is epitaxially grown. In a next fabrication step 308, different lateral silicon-on-insulator regions with different thicknesses of the silicon layer above the buried oxide layer are fabricated. The step 308 fabricating the different SOI regions comprises thinning the silicon layer partially using a laterally structured mask, which protects the optical SOI regions. The silicon layer is thinned by a sequence of reactive ion etching (RIE) and wet etching steps. Alternatively, thinning can be done by thermal oxidation and subsequent removing, preferably by a wet etching step, the formed silicon oxide layer.

As alternative to step 308, fabricating the different SOI regions comprises partially thickening the silicon layer using a laterally structured mask, which protects here the electrical SOI regions.

The different thicknesses of the structured silicon layer above the buried oxide layer form protrusions for some of the different thicknesses. In a further fabrication step 310, an oxidation of the front surface of the silicon multifunction substrate after fabricating the different lateral SOI regions is carried out.

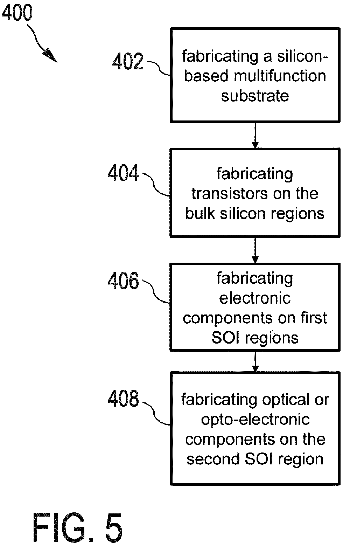

Fig. 5 shows a block diagram of an embodiment of the method 400 for fabricating an integrated circuit device 200 of Fig. 3. A first step 402 of this method is fabricating a silicon multifunction substrate with the method explained in context of Fig. 4. In a second step 404, bipolar transistors are fabricated on top of the bulk silicon region. Thus, a bulk silicon electronic region is formed. In a third step 406, electronic components are fabricated on top of the first SOI region forming an electrical SOI region. In a last step 408, optical or opto-electronic components are fabricated on top of the second SOI region forming an optical SOI region.

In summary, the invention relates to a silicon-based multifunction substrate. The multifunction substrate comprises bulk silicon regions extending from a front surface to a back surface of the silicon-based multifunction substrate and at least one buried oxide layer laterally arranged between the bulk silicon regions. The buried oxide layer is covered by a structured silicon layer extending up to the front surface. The structured silicon layer comprises, laterally arranged between the bulk silicon regions, at least two silicon-on-insulator regions, herein SOI regions, with different thicknesses above the buried oxide layer. The SOI regions of the structured silicon layer are electrically insulated from each other by a respective first trench isolation extending from the front surface to the buried oxide layer.

## Claims

1. A silicon-based multifunction substrate (100), comprising:
- bulk silicon regions (102) extending from a front surface (104) to a back surface (106) of the silicon multifunction substrate (100);
- at least one buried oxide layer (108.1, 108.2) laterally arranged between the bulk silicon regions (102); wherein
- the buried oxide layer (108.1, 108.2) is covered by a structured silicon layer (110.1, 110.2) extending up to the front surface (104) to form a silicon-on-insulator, herein SOI, substrate region, the SOI substrate region comprising, laterally arranged between the bulk silicon regions, at least two silicon-on-insulator regions (112.1, 112.2, 114.1, 112.3, 112.4, 114.2) with different thicknesses (t2, t3) of the structured silicon layer above the buried oxide layer (108.1, 108.2); and wherein
- the SOI regions (112.1, 112.2, 114.1, 112.3, 112.4, 114.2) of the structured silicon layer (110.1, 110.2) are electrically insulated from each other by a respective first trench isolation (116.1, 116.2, 116.3, 116.4) extending from the front surface (104) to the buried oxide layer (108.1, 108.2).

2. The silicon-based multifunction substrate (100) according to claim 1, wherein
- the structured silicon layer (110.1, 110.2) comprises only two types of SOI regions (112.1, 112.2, 114.1, 112.3, 112.4, 114.2), namely at least one first SOI region (112.1, 112.2, 112.3, 112.4) and at least one second SOI region (114.1, 114.2);
- the first SOI region (112.1, 112.2, 112.3, 112.4) has a first thickness and extends in thickness from the buried oxide layer (108.1, 108.2) to a first thickness level that is on an identical plane with the front surface (104) of the bulk silicon region (102); and
- the second SOI region (114.1, 114.2) has a second thickness (t₃) larger than the first thickness (t₂) and extends from the buried oxide layer (108.1, 108.2) to second thickness level, which is on a plane different from that of the front surface (104) of the bulk silicon region (102) and thus forms a protrusion.

3. The silicon-based multifunction substrate (100) according to claim 2, wherein the first SOI region (112.1, 112.2, 112.3, 112.4) of the structured silicon layer (110.1, 110.2) is laterally arranged between the second SOI region (114.1, 114.2) and the bulk silicon region (102).

4. The silicon-based multifunction substrate (100) according to claim 3, wherein a lateral extension (W₁) of the first SOI region (112.1, 112.2, 112.3, 112.4) is larger than 100 nanometer.

5. The silicon-based multifunction substrate (100) according to any of the preceding claims, wherein the first SOI region (112.1, 112.2, 112.3, 112.4) and the bulk silicon region (102) are electrically insulated from each other by a second trench isolation (118.1, 118.2, 118.3, 118.4) extending in a depth direction (D) from the front surface (104) to a depth level deeper than to a depth level that is deeper than an upper edge of the buried oxide layer (108.1, 108.2).

6. The silicon-based multifunction substrate (100) according to claim 5, wherein a lateral width on a bulk silicon side (W_{STb}) of the second trench isolation (118.1, 118.2, 118.3, 118.4), is larger than the sum of a thickness of the buried oxide layer and the largest thickness of the structured silicon layer thicknesses.

7. An integrated circuit device (200), comprising
- a silicon-based multifunction substrate (100) for monolithic integration of electronic and optoelectronic devices according to any of the preceding claims, wherein
- active or passive electronic components (202) are arranged on or within the bulk silicon regions (102) forming a bulk electrical region, and wherein
- optical or opto-electronic components (204.1, 204.2) are arranged on top of or within that SOI region (114.1, 114.2) of the structured silicon layer (110.1, 110.2), which among the at least two SOI regions has a largest thickness above the buried oxide layer (108.1, 108.2).

8. The integrated circuit device (200) according to claim 7, comprising a silicon-based multifunction substrate (100) for monolithic integration of electronic and optoelectronic devices according to claim 2, wherein
- further active electronic components (206.1, 206.2) are arranged on top of or within the first SOI region (112.1, 112.2, 112.3, 112.4) forming an electrical SOI region; and wherein
- the optical or opto-electronic components (204.1, 204.2) are arranged on top of or within the second SOI region (114.1, 114.2) forming an optical SOI region.

9. The integrated circuit device (200) according to claim 8, wherein the further active electronic components (206.1, 206.2) comprise MOS components arranged on the electrical SOI region, which is laterally arranged between the optical SOI region and the bulk electrical region.

10. The integrated circuit device (200) according to any of the claims 7 to 9, wherein the active electronic components (202) comprise active electronic radio-frequency components configured to receive electrical radio frequency signals or to provide electrical radio frequency signals.

11. A method (300) fabricating a silicon-based multifunction substrate, the method comprising
- providing (302) a silicon-on-insulator substrate that comprises a buried oxide layer and a silicon layer which is arranged on the buried oxide layer;
- forming (304) at least one trench extending in a depth direction through the silicon layer and through the buried oxide layer;
- depositing (306) silicon inside the trench to form a bulk silicon region that extends from a front surface to a back surface of the silicon multifunction substrate; and
- fabricating (308, 309) different silicon-on-insulator regions, herein SOI regions, with different thicknesses (t2, t3) of the silicon layer above the buried oxide layer, including a first SOI region having a first thickness and a second SOI region having a second thickness larger than the first thickness.

12. The method (300) of claim 11, wherein fabricating the different SOI regions (308) comprises thinning the silicon layer partially using a laterally structured mask.

13. The method (300) of claim 11, wherein fabricating the different SOI regions (308) comprises forming partially thickening the silicon layer using an epitaxial growth process and a laterally structured mask.

14. The method (300) of any of the claims 11 to 13, further comprising an oxidation (310) of the front surface of the silicon-based multifunction substrate after fabricating the different SOI regions.

15. A method (400) for fabricating an integrated circuit device, comprising
- fabricating (402) a silicon-based multifunction substrate according to the method of any of the claims 11 to 14;
- fabricating (404) transistors on at least one of the bulk silicon regions, thus forming bulk silicon electronic regions;
- fabricating (406) at least one electronic component on of the at least one first SOI region; and
- fabricating (408) at least one optical or opto-electronic component on the second SOI region.
